# EUROPÄISCHE PATENTSCHRIFT

(11) **EP 0 563 695 B1**
(45) Veröffentlichungstag und Bekanntmachung des Hinweises auf die Patenterteilung: **26.05.1999**
(21) Anmeldenummer: 93104480.4
(22) Anmeldetag: 18.03.1993
(51) Int. Cl.: G01R 31/02

(54) **Verfahren und Anordnung zur Erkennung von Kurzschlüssen in Leitungsabzweigen von elektrischen Netzen**
Method and means for detecting short circuits in parts of electrical networks
Procédé et dispositif pour déterminer des court-circuits dans des branches de réseaux électriques

(30) Priorität: 31.03.1992 DE 4210614
(43) Veröffentlichungstag der Anmeldung: 06.10.1993
(73) Patentinhaber: SIEMENS AKTIENGESELLSCHAFT, 80333 München (DE)
(72) Erfinder: Maier, Reinhard, Dr., W-8522 Herzogenaurach (DE); Röthlingshöfer, Walter, W-8520 Erlangen (DE)

(56) Entgegenhaltungen:
- DE-A- 3 347 209
- DE-A- 3 626 399

## Beschreibung

Die Erfindung bezieht sich auf ein Verfahren zur Erkennung von Kurzschlüssen in Leitungsabzweigen von elektrischen Netzen, bei dem der Leitungsabzweig in einem Prüfschritt mit einem Spannungsimpuls beaufschlagt, der fließende Strom gemessen und einer Auswerteschaltung mit Soll- und Istwertvergleich zugeführt wird. Daneben bezieht sich die Erfindung auf die zugehörige Schaltungsanordnung mit Mitteln zur Erzeugung von Prüfimpulsen und mit Mitteln zur Anschaltung der Prüfimpulse an den zu prüfenden Leitungsabzweig sowie mit Auswertemitteln zur Meßwerterfassung des gemessenen Stromes und Vergleich mit vorgegebenen Grenzwerten.

Zum Schalten von elektrischen Abzweigen werden üblicherweise Leistungsschalter verwendet. Das Einschalten eines kurzschlußbehafteten Abzweiges, z.B. bei der Inbetriebnahme einer fehlerhaften Anlage, stellt dabei eine der stärksten Beanspruchungen für den vorhandenen Leistungsschalter dar. Dies rührt daher, daß der Schalter zunächst seinen Schließvorgang beenden muß, und dann erst der Ausschaltvorgang stattfindet, so daß damit die Kurzschlußdauer sehr groß wird. Beim Einschalten einer fehlerhaften Anlage ist zudem der Widerstand des gesamten Kreises sehr gering und damit der Kurzschlußstrom groß.

Insbesondere ein Leistungsschalter, aber auch andere Betriebsmittel könnten schwächer und damit kostengünstiger dimensioniert werden, wenn vor dem Zuschalten eine automatisch durchgeführte Prüfung auf bestehenden Kurzschluß erfolgen kann. Dabei muß die Prüfdauer so kurz sein, daß keine merkliche Einschaltverzögerung auftritt, d.h. etwa in der Größenordnung von weniger als einer Sekunde.

Aus der DE-OS 36 26 399 ist bereits eine Anordnung zur Beeinflussung, insbesondere Blockierung eines Schaltgerätes, vorzugsweise eines fernbetätigten Schaltgerätes, in Abhängigkeit von Netzzustandsdaten bekannt, bei dem eine Fremdspannungseinspeisung und eine nachgeschaltete Auswerteschaltung mit Soll- und Istwertvergleich erfolgt. Zur Fremdspannungseinspeisung ist dort ein Stoßgenerator zur Erzeugung von Prüfimpulsen aus Kondensatorentladungen und eine Auswerteschaltung vorgesehen, die den Spitzenwert der umgesetzten elektrischen Momentanleistung ermittelt. Weiterhin ist aus der DE-OS 33 47 209 eine Anordnung zur Beeinflussung eines Schaltgerätes durch Impedanzbestimmung des Abzweiges und Vergleich mit voreingestellten Werten bekannt.

Mit den vorbekannten Anordnungen lassen sich zwar insbesondere bei einem Motor Kurzschlüsse, Windungsschlüsse und Unterbrechungen in der Zuleitung zweifelsfrei und rasch nachweisen. Weniger geeignet sind diese Anordnungen zur Erkennung bestehender Kurzschlüsse in beliebigen Netzen.

Aufgabe der Erfindung ist es daher, ein Verfahren vorzuschlagen und die zugehörige Schaltungsanordnung zu schaffen, mit denen Kurzschlüsse in Leitungsabzweigen beliebiger Netze erkannt werden können.

Die Aufgabe ist erfindungsgemäß bei einem Verfahren der eingangs genannten Art dadurch gelöst, daß der Spannungsimpuls als Impuls kurzer Dauer durch direktes kurzzeitiges Anlegen der Netzspannung an den Leitungsabzweig erzeugt wird und daß bei Beaufschlagung des Leitungsabzweiges mit dem Puls kurzer Dauer allein der gemessene Strom einer vergleichenden Bewertung unterzogen wird. Vorzugsweise wird dabei der Strommeßwert integriert und durch Vergleich des integrierten Strommeßwertes mit einem Vergleichswert ein Kurzschluß vom Einschalten eines beliebigen Verbrauchers unterschieden.

Für die Erkennung des Kurzschlusses wird die Auswertung des Strommeßwertes im allgemeinen analog durchgeführt. Es kann aber auch vorgesehen sein, daß eine Bewertung des gemessenen Stromes nach Digitalisierung unter Software-Einsatz erfolgt und daß dabei neben der digitalen Integration durch Summenbildung insbesondere die Methode der Mustererkennung angewandt wird.

Bei der zugehörigen Anordnung ist eine Leistungshalbleiter-Schaltung mit einem GTO ("gate-turn-off")-Thyristor vorhanden, wobei der GTO in einen dem Leitungsabzweig vorgelagerten Prüfzweig geschaltet ist und im Zeitpunkt des Scheitelwertes der Netzspannung für eine einstellbare Zeit gezündet wird.

Im Rahmen der Erfindung konnte gezeigt werden, daß speziell das Stromintegral eine Größe ist, mit der sich Verbraucher, wie Widerstände, Motoren, Kondensatoren sowie deren Mischformen eindeutig von einem Kurzschluß unterscheiden lassen. Die Prüfdauer ist mit 0,5 ms im tolerierbaren Bereich.

Weitere Einzelheiten und Vorteile der Erfindung ergeben sich aus der nachfolgenden Figurenbeschreibung eines Ausführungsbeispiels anhand der Zeichnung. Es zeigen
- Figur 1: anhand eines Prinzipschaltbildes das Verfahren zur Erkennung bestehender Kurzschlüsse,
- Figur 2: die spezifische Schutzbeschaltung für einen GTO und
- Figur 3 a und b: Diagramme zur Verdeutlichung des erfindungsgemäß angestrebten Zieles der Diskriminierung von eingeschalteten Verbrauchern von vorliegenden Kurzschlüssen.

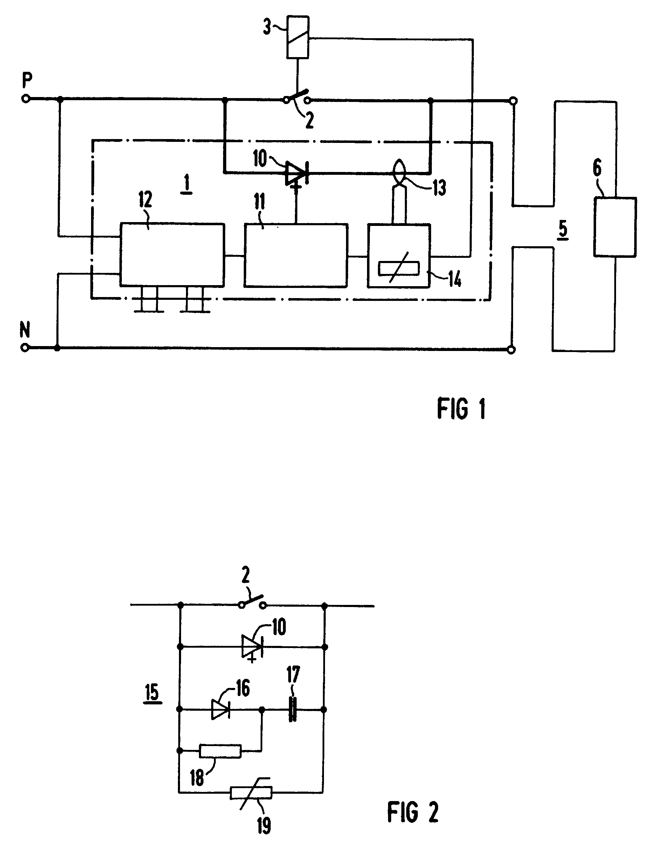

In Figur 1 besteht eine Schaltungsanordnung neben den Leitungen aus einem Prüfzweig 1 und einem Leitungsabzweig 5 mit Verbraucher 6 sowie einem Abzweigschalter 2, der über eine Betätigungsspule 3 aktiviert wird. Der Verbraucher 6 kann Ohm'sche oder kapazitive Widerstände und weiterhin Induktivitäten aufweisen und insbesondere durch einen Motor realisiert sein.

Parallel zum Abzweigschalter 2 ist ein Thyristor 10 geschaltet, der als sogenannter GTO ("gate-turn-off") ausgebildet ist. Dem GTO 10 ist eine Steuereinheit 11 zur Zündung, ein Erkennungsglied 12 für die Phasenlage der Netzspannung mit Generierung von Schaltbefehlen und ein Stromwandler 13 mit Integriereinrichtung 14 zugeordnet.

Durch die im einzelnen angegebenen Prüfmittel soll der Abzweigschalter 2 über die Betätigungsspule 3 so gesteuert werden, daß bei Erkennen eines Kurzschlusses der Schalter 2 blockiert wird, so daß kein Einschalten erfolgt.

Im Prüfzweig wird ein Prüfimpuls dadurch erzeugt, daß der GTO 10 im Zeitpunkt des Scheitelwertes der Netzspannung gezündet und nach einer eingestellten Zeit wieder abgeschaltet wird. Damit ist bei der Prüfung auf Kurzschluß automatisch die richtige Spannungshöhe, nämlich ungefähr die Scheitelspannung des Netzes, gewährleistet. Die Schaltung ist beliebig ergiebig, da der Strom im wesentlichen nur durch den Netzinnenwiderstand begrenzt wird und somit die Prüfzeit sehr kurz ist. Der GTO 10 wird von der Einheit 11 angesteuert. Dafür wird im Erkennungsglied 12 der Nulldurchgang der Netzspannung detektiert und die Zündung erfolgt über ein einstellbares Zeitglied. Ein weiteres Zeitglied gibt die Impulsdauer vor.

Insbesondere wird mit der Schaltung gemäß Figur 1 aus der Netzspannung elektronisch ein annähernder Rechteckimpuls von ca. 0,5 ms Dauer erzeugt, mit dem der zu prüfende Abzweig beaufschlagt wird. Mittels Stromwandler 13 wird der fließende Strom gemessen, integriert und mit einem (nichtdargestellten) Schwellwertdetektor der Kurzschluß vom Einschalten auf einen beliebigen Verbraucher unterschieden.

In Figur 2 ist dem dem Abzweigschalter 2 parallel geschalteten GTO 10 eine Schutzbeschaltung 15 zugeordnet. Sie besteht im einzelnen aus der Parallelschaltung einer Diode 16 mit nachgeschalteter Kapazität 17 und eines Ohm'schen Widerstandes 18. Derartige Schutzschaltungen sind als sog. Snubberkreise bekannt. Weiterhin ist zur Spannungsbegrenzung ein Varistor 19 parallelgeschaltet.

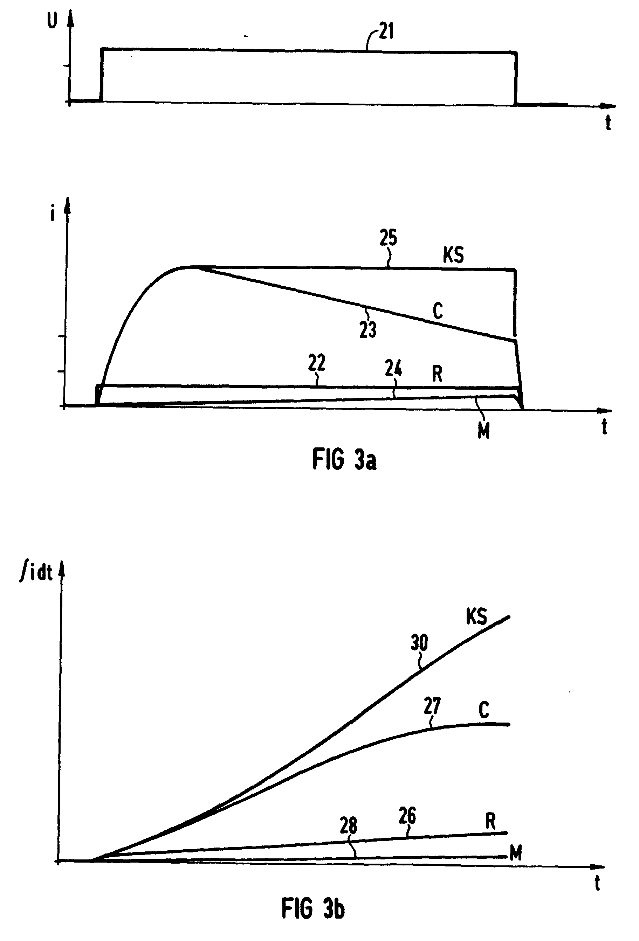

In Figur 3 sind die Kennlinien für unterschiedliche Fälle dargestellt. Im einzelnen bedeuten 21 die Spannung entsprechend dem Prüfimpuls sowie 22 bis 24 den Stromverlauf und 26 bis 28 das Stromintegralsignal für unterschiedliche Verbraucher. Die Kennlinien 25 und 30 zeigen dagegen den Kurzschlußfall. Der Stromverlauf ist überwiegend durch die Art des am Abzweig angeschlossenen Verbrauchers, die Spannung dagegen durch die Einspeisung bestimmt. Die Innenimpedanz der Einspeisung hat bei Verbrauchern, die im Nenn- oder Uberlastbereich arbeiten, nur unwesentlichen Einfluß auf den Stromverlauf. Dagegen bestimmt im Kurzschlußfall die Innenimpedanz den Stromverlauf: Im einzelnen sind zum Vergleich die Signalverläufe bei Verbrauchern R, C und einem Motor, der überwiegend induktiv ist, sowie beim Kurzschluß dargestellt. Dabei sind die Verbraucher so gewählt, daß im Nennbetrieb der maximal zulässige Strom fließt.

Es wurde festgestellt, daß der Spannungsverlauf in allen Fällen in etwa gleich verläuft. Bei einem Widerstand R als Verbraucher verläuft der Strom gemäß Graph 22 ebenso rechteckförmig wie die Spannung. Der Wert für das Stromintegralsignal steigt gemäß Graph 26 in etwa linear an.

Da ein Kondensator C im ersten Moment wie ein Kurzschluß wirkt, steigt hier der Strom gemäß Graph 23 zunächst mit einer Anstiegsgeschwindigkeit an, die durch die Spannung und die gesamte Inneninduktivität gegeben ist. Später fällt der Strom ab. Das Stromintegralsignal gemäß Graph 27 steigt dagegen auf einen Endwert an, der wesentlich größer ist als beim Widerstand.

Bei einem Motor M tritt im Vergleich zum Widerstand ein noch geringerer Strom gemäß Graph 24 und ebenfalls ein erheblich kleinerer Stromintegralwert gemäß Graph 28 auf.

Im Kurzschlußfall KS verläuft dagegen der Strom gemäß Graph 25 zu Anfang zwar wie bei einem Kondensator und bleibt dann allerdings im wesentlichen konstant. Im Vergleich zu allen vorhergehenden Fällen steigt das Stromintegralsignal gemäß Graph 30 auf einen höheren Endwert.

Figur 3 zeigt also insgesamt, daß bei unterschiedlichem Stromverlauf das Stromintegral signifikante Unterschiede hat. Experimentelle Untersuchungen haben ergeben, daß Widerstände und Induktivitäten sowie deren Mischformen, wie z.B. Motoren, somit eindeutig vom Kurzschluß unterschieden werden können.

Da der Stromverlauf beim Kondensator und Kurzschluß am wenigsten voneinander abweichen, sind diese am schwersten zu unterscheiden. Die Unterscheidung wird aber um so eindeutiger, Je länger der Impuls andauert, da das maximale Stromintegral die im Kondensator gespeicherte Ladung bedeutet und damit endlich ist, während die Ladungsmenge im Kurzschlußfall beliebig mit der Impulsdauer ansteigt.

Die Impulsdauer ist daher beim erfindungsgemäßen Verfahren entsprechend den zu verwendenden Kondensatoren zu wählen. Da die in der Praxis verwendeten Kondensatoren eine vorgegebene Kapazität nicht überschreiten, dürfte im allgemeinen eine Impulsdauer von 0,5 ms hinreichend sein. Letzteres gilt insbesondere dann, wenn der Kurzschluß nicht unmittelbar am Ort des Verbrauchers sondern auf der Zuleitung auftritt, was wegen der verringerten Zuleitungsimpedanz zu einem höheren Kurzschlußstrom führt.

Bei Figur 1 wurde zur Strommessung, -integration und Schwellwertvergleich ein weitgehend analoges Meßverfahren angewendet. Es ist aber auch möglich, den Strommeßwert digital auszuwerten. Hierzu wird statt der Integriereinrichtung 14 ein Prozessor verwendet, dem ein AD-Wandler vorgeschaltet ist. Mit einem solchen Prozessor kann neben der digitalen Integration durch Summenbildung insbesondere die Methode der Mustererkennung durchgeführt werden, wofür in der Praxis geeignete Softwareprogramme zur Verfügung stehen.

## Patentansprüche

1. Verfahren zur Erkennung von Kurzschlüssen in Leitungsabzweigen (5) von elektrischen Netzen, bei dem der Leitungsabzweig (5) in einem Prüfschritt mit einem Spannungsimpuls beaufschlagt, der fließende Strom gemessen und einer Auswerteschaltung mit Soll- und Istwertvergleich zugeführt wird, **dadurch gekennzeichnet,** daß der Spannungsimpuls als Puls kurzer Dauer durch direktes kurzzeitiges Anlegen der Netzspannung an den Leitungsabzweig (5) erzeugt wird und daß bei Beaufschlagung des Leitungsabzweiges (5) mit dem Puls kurzer Dauer allein der gemessene Strom einer vergleichenden Bewertung unterzogen wird.

2. Verfahren nach Anspruch 1, **dadurch gekennzeichnet,** daß der Strommeßwert integriert und durch Vergleich des integrierten Strommeßwertes mit einem Vergleichswert ein Kurzschluß vom Einschalten eines beliebigen Verbrauchers (6) unterschieden wird.

3. Verfahren nach Anspruch 1, **dadurch gekennzeichnet,** daß der Impuls annähernd ein Rechteckimpuls ist.

4. Verfahren nach Anspruch 3, **dadurch gekennzeichnet,** daß der Rechteckimpuls eine solche Dauer hat, daß sich bei maximal zulässigem Strom für einen Kondensator als Verbraucher im Leitungsabzweig (5) das Stromintegral von einem Kurzschluß unterscheidet.

5. Verfahren nach Anspruch 4, **dadurch gekennzeichnet,** daß bei einem Kondensator mit C = 200 µF eine Impulsdauer von 0,5 ms gewählt wird.

6. Verfahren nach Anspruch 3, **dadurch gekennzeichnet,** daß der Rechteckimpuls aus der Netzspannung elektronisch erzeugt wird.

7. Verfahren nach Anspruch 3, **dadurch gekennzeichnet,** daß die Amplitude des Rechteckimpulses in etwa in der Höhe der Scheitelspannung im Netz gewählt wird.

8. Verfahren nach Anspruch 1, **dadurch gekennzeichnet**, daß der Vergleich des integrierten Stromes mit einem Vergleichswert in einem Schwellwertdetektor erfolgt.

9. Verfahren nach Anspruch 1, **dadurch gekennzeichnet**, daß die vergleichende Bewertung des gemessenen Stromes digital unter Software-Einsatz erfolgt.

10. Verfahren nach Anspruch 9, **dadurch gekennzeichnet**, daß eine Integralbildung durch Summation der digitalisierten Stromwerte durchgeführt wird.

11. Verfahren nach Anspruch 9, **dadurch gekennzeichnet,** daß die Methode der Mustererkennung angewandt wird.

12. Anordnung zur Durchführung des Verfahrens nach Anspruch 1 oder einem der Ansprüche 2 bis 11, mit Mitteln (10,11) zur Erzeugung von Prüfimpulsen und mit Mitteln zur Anschaltung der Prüfimpulse an den zu prüfenden Leitungsabzweig (5) sowie mit Auswertemitteln zur Meßwerterfassung des gemessenen Stroms und Vergleich mit vorgegebenen Grenzwerten, **dadurch gekennzeichnet,** daß eine Leistungshalbleiter-Schaltung mit einem GTO-Thyristor (10) zur Erzeugung von Spannungsimpulsen als Prüfimpulsen kurzer Dauer vorhanden ist, wobei der GTO-Thyristor (10) in einen dem Leitungsabzweig (5) vorgelagerten Prüfzweig (1) geschaltet ist und im Zeitpunkt des Scheitelwertes der Netzspannung für eine einstellbare Zeit gezündet wird.

13. Anordnung nach Anspruch 12, **dadurch gekennzeichnet,** daß dem GTO-Thyristor (10) eine Schutzbeschaltung (15) zur Begrenzung der Spannung zugeordnet ist, die einen RCD-Snubberkreis (16 - 18) enthält.

14. Anordnung nach Anspruch 12, **dadurch gekennzeichnet**, daß die Schutzbeschaltung (15) zur Begrenzung der Spannung am GTO-Thyristor (10) einen Varistor (19) enthält.

## Claims

1. Method for the detection of short circuits in line branches (5) of electrical systems, where the line branch (5) receives a voltage pulse in a test step, the flowing current is measured and is supplied to an evaluation circuit with desired and actual value comparison, characterized in that the voltage pulse is generated as a pulse of short duration by means of direct short-time application of the system voltage to the line branch (5), and in that when the line branch (5) receives the pulse of short duration only the measured current undergoes a comparative evaluation.

2. Method according to claim 1, characterized in that the current measured value is integrated and by means of comparison of the integrated current measured value with a comparison value a short circuit is differentiated from the switching-on of an arbitrary consumer (6).

3. Method according to claim 1, characterized in that the pulse is approximately a square-wave pulse.

4. Method according to claim 3, characterized in that the square-wave pulse has such a duration that, with maximum permitted current for a capacitor as consumer in the line branch (5), the current integral is differentiated from a short circuit.

5. Method according to claim 4, characterized in that with a capacitor where C = 200 µF a pulse duration of 0.5 ms is selected.

6. Method according to claim 3, characterized in that the square-wave pulse is generated electronically from the system voltage.

7. Method according to claim 3, characterized in that the amplitude of the square-wave pulse is selected to a certain extent at the level of the peak voltage in the system.

8. Method according to claim 1, characterized in that the comparison of the integrated current with a comparison value takes place in a threshold value detector.

9. Method according to claim 1, characterized in that the comparative evaluation of the measured current takes place digitally with the use of software.

10. Method according to claim 9, characterized in that an integral formation is carried out by means of summation of the digitized current values.

11. Method according to claim 9, characterized in that the method of pattern recognition is used.

12. Arrangement for carrying out the method according to claim 1 or one of claims 2 to 11, having means (10, 11) for generating test pulses and having means for connecting the test pulses to the line branch (5) to be tested, and having evaluation means for measured-value detection of the measured current and comparison with specified limiting values, characterized in that there is a power semiconductor circuit with a GTO thyristor (10) for generating voltage pulses as test pulses of short duration, with the GTO thyristor (10) being connected into a test branch (1) lying in front of the line branch (5), and being ignited at the instant of the peak value of the system voltage for an adjustable time.

13. Arrangement according to claim 12, characterized in that a protective circuit (15) for limiting the voltage is allocated to the GTO thyristor (10), the protective circuit containing an RCD snubber circuit (16 - 18).

14. Arrangement according to claim 12, characterized in that the protective circuit (15) for limiting the voltage at the GTO thyristor (10) contains a varistor (19).

## Revendications

1. Procédé pour identifier des courts-circuits dans des bifurcations (5) de ligne de réseaux électriques, dans lequel, à une étape de test, on alimente la bifurcation (5) de ligne en une impulsion de tension, on mesure le courant qui passe et on l'envoie à un circuit d'exploitation à comparaison de valeur de consigne et de valeur réelle, caractérisé en ce que l'on produit l'impulsion de tension comme impulsion de courte durée par application directe pendant peu de temps de la tension du réseau à la bifurcation (5) de ligne et en ce que, lors de l'alimentation de la bifurcation (5) de ligne en l'impulsion de courte durée, seul le courant mesuré est soumis à une évaluation de comparaison.

2. Procédé suivant la revendication 1, caractérisé en ce que l'on intègre la valeur de mesure de courant et en ce que l'on différencie un court-circuit du branchement d'un appareil (6) utilisateur quelconque par comparaison de la valeur de mesure de courant intégrée à une valeur de comparaison.

3. Procédé suivant la revendication 1, caractérisé en ce que l'impulsion est une impulsion à-peu-près rectangulaire.

4. Procédé suivant la revendication 3, caractérisé en ce que l'impulsion rectangulaire a une durée telle que, pour un courant admissible au maximum, pour un condensateur servant d'appareil d'utilisateur dans la bifurcation (5) de ligne, l'intégrale du courant le distingue d'un court-circuit.

5. Procédé suivant la revendication 4, caractérisé en ce que, pour un condensateur de C=200 µF, on choisit une durée d'impulsion de 0,5 ms.

6. Procédé suivant la revendication 3, caractérisé en ce que l'impulsion rectangulaire est produite de manière électronique à partir de la tension du réseau.

7. Procédé suivant la revendication 3, caractérisé en ce que l'amplitude de l'impulsion rectangulaire est choisie à-peu-près au niveau de la tension de pic dans le réseau.

8. Procédé suivant la revendication 1, caractérisé en ce que la comparaison du courant intégré à une valeur de comparaison s'effectue dans un détecteur de valeur seuil.

9. Procédé suivant la revendication 1, caractérisé en ce que l'évaluation de comparaison du courant mesuré s'effectue de manière numérique avec utilisation de logiciel.

10. Procédé suivant la revendication 9, caractérisé en ce que l'on effectue une formation intégrale par sommation des valeurs du courant numérisées.

11. Procédé suivant la revendication 9, caractérisé en ce que l'on utilise la méthode de l'identification de modèles.

12. Dispositif pour mettre en oeuvre le procédé suivant la revendication 1 ou l'une des revendications 2 à 11, comportant des moyens (10,11) pour produire des impulsions de test et des moyens pour appliquer les impulsions de test à la bifurcation (5) de ligne à tester, ainsi que des moyens d'exploitation pour la détection de valeur de mesure du courant mesuré et la comparaison à des valeurs de mesure prescrites, caractérisé en ce qu'il est présent un circuit à semistor de puissance comportant un thyristor (10) GTO pour produire des impulsions de tension comme impulsions de test de brève durée, le thyristor (10) GTO étant branché dans une branche (1) de test en amont de la bifurcation (5) de ligne et étant amorcé à l'instant de la valeur de pic de la tension du réseau, pour une durée réglable.

13. Dispositif suivant la revendication 12, caractérisé en ce qu'il est associé au thyristor (10) GTO un câblage (15) de protection pour limiter la tension, qui contient un circuit (16 - 18) RCD-Snubber.

14. Dispositif suivant la revendication 12, caractérisé en ce que le câblage (15) de protection servant à limiter la tension sur le thyristor (10) GTO contient un varistor (19).
